# EUROPÄISCHE PATENTSCHRIFT

(11) **EP 2 874 476 B1**
(45) Veröffentlichungstag und Bekanntmachung des Hinweises auf die Patenterteilung: **09.05.2018**
(21) Anmeldenummer: 14187028.7
(22) Anmeldetag: 30.09.2014
(51) Int. Cl.: H05K 1/14, H05K 3/40

(54) **Basisleiterplatte, Modulleiterplatte und Leiterplattenanordnung mit einer Basisleiterplatte und einer Modulleiterplatte**
Printed circuit base board, module circuit board and circuit board assembly with a base board and a module circuit board
Carte de circuit imprimé de base, carte modulaire de circuit imprimé, système de cartes de circuit imprimé doté d'une carte de circuit imprimé de base et d'une carte modulaire de circuit imprimé

(30) Priorität: 14.11.2013 DE 102013223209
(43) Veröffentlichungstag der Anmeldung: 20.05.2015
(73) Patentinhaber: Siemens Aktiengesellschaft, 80333 München (DE)
(72) Erfinder: Frank, Andre, 15366 Neuenhagen (DE)

(56) Entgegenhaltungen:
- EP-A1- 2 063 694
- EP-A1- 2 566 310
- WO-A1-2013/096983
- JP-A- H10 290 054
- JP-A- 2001 237 551

## Beschreibung

Die Erfindung betrifft eine Basisleiterplatte zur Aufnahme von elektrischen und/oder elektronischen Komponenten, wobei die Basisleiterplatte elektrische Leiterbahnen aufweist, wobei in der Basisleiterplatte zumindest eine Aussparung vorgesehen ist, die zur Aufnahme einer Modulleiterplatte in der Weise ausgebildet ist, dass bei in die Aussparung eingefügter Modulleiterplatte diese mit der Basisleiterplatte in einer Ebene angeordnet ist, wobei die Aussparung der Basisleiterplatte zum Herstellen einer Klemmverbindung mit der Modulleiterplatte eingerichtet ist, wobei zum Herstellen der Klemmverbindung die Aussparung der Basisleiterplatte mindestens an einer Innenkante mindestens ein federndes Element aufweist, das derart ausgebildet ist, dass es bei eingefügter Modulleiterplatte eine Klemmkraft gegen eine entsprechende Außenkante der Modulleiterplatte ausübt. Daneben betrifft die Erfindung auch eine Modulleiterplatte zur Aufnahme von elektrischen und/oder elektronischen Komponenten, wobei die Modulleiterplatte elektrische Leiterbahnen aufweist, wobei die Modulleiterplatte dazu ausgebildet ist, in eine Aussparung einer Basisleiterplatte derart eingefügt zu werden, dass bei in die Aussparung eingefügter Modulleiterplatte diese mit der Basisleiterplatte in einer Ebene angeordnet ist, wobei die Modulleiterplatte zum Herstellen einer Klemmverbindung in der Aussparung der Basisleiterplatte eingerichtet ist, wobei zum Herstellen der Klemmverbindung die Modulleiterplatte mindestens an einer Außenkante mindestens ein federndes Element aufweist, das derart ausgebildet ist, dass es bei in die Aussparung der Basisleiterplatte eingefügter Modulleiterplatte eine Klemmkraft gegen eine entsprechende Innenkante der Aussparung ausübt. Außerdem betrifft die Erfindung eine Leiterplattenanordnung bestehend aus einer solchen Basisleiterplatte und einer solchen Modulleiterplatte.

Eine solche Basisleiterplatte ist z. B. aus der JP 2001-237551 A bekannt. Auch die EP 2 566 310 A1 und der EP 2 063 694 A1 zeigen solche Basisleiterplatten.

Leiterplatten zur Aufnahme elektrischer und/oder elektronischer Komponenten werden in nahezu allen elektrischen Geräten eingesetzt. Sie bieten einerseits eine Montagefläche für die miteinander zusammenwirkenden elektrischen und/oder elektronischen Komponenten und stellen andererseits auch elektrische Verbindungen zwischen diesen Komponenten in Form von Leiterbahnen zur Verfügung.

Häufig werden auf derselben Leiterplatte Komponenten unterschiedlichen Typs untergebracht ("Mischbestückung"), beispielsweise weisen solche Komponenten eine unterschiedliche Integrationsdichte auf, die sich besonders an der Anzahl der elektrischen Anschlüsse einer solchen Komponente widerspiegelt. Komponenten mit hoher Integrationsdichte sind beispielsweise integrierte Halbleiter, wie z.B. Speicherbausteine, Prozessoren und IC-Bausteine, während Komponenten mit niedriger Integrationsdichte beispielsweise "konventionelle" elektrische Bausteine, wie z.B. Widerstände, Kondensatoren, Relais, Messwandler etc., sind. Bei Verwendung von Komponenten unterschiedlicher Integrationsdichte auf derselben Leiterplatte werden die Anforderungen an die Eigenschaften der Leiterplatte generell von den anspruchsvollsten Komponenten (z.B. den Komponenten mit der höchsten Integrationsdichte) festgelegt, auch wenn diese nur einen vergleichsweise geringen Anteil der Fläche der Leiterplatte belegen, so dass auch die Kosten für die Leiterplatte maßgeblich durch diese Komponenten bestimmt werden.

Als Eigenschaften einer Leiterplatte werden generell alle die Komplexität der Fertigung der Leiterplatte beeinflussenden Kriterien angesehen, z.B. eine Anzahl von Schichten einer Leiterplatte ("Singlelayer", "Multilayer"), eine Oberflächenbeschichtung oder eine zum Aufbringen der Komponenten benötigte Bestückungstechnologie.

Daneben treiben auch unterschiedliche Versionen von Leiterplatten Entwicklungs-, Test- und Lagerhaltungskosten in die Höhe. So kann es beispielsweise vorkommen, dass sich mehrere Versionen einer ansonsten identisch aufgebauten Leiterplatte lediglich durch die Art eines eingesetzten Spezialmoduls unterscheiden, wodurch Aufwand und Kosten für jede einzelne Version erzeugt werden. So kann beispielsweise die flexible Auswahl der Art eines Kommunikationsmoduls (z.B. RS232, Profibus, ZigBee etc.) bei ansonsten gleicher Ausgestaltung der Leiterplatte dafür verantwortlich sein, dass entsprechend viele Versionen einer Leiterplatte hergestellt und bereitgehalten werden müssen. Auch diese Form von einerseits festen und andererseits variablen Komponenten der Leiterplatte soll im Folgenden als Mischbestückung bezeichnet werden.

Um die Kosten einer Leiterplatte mit Mischbestückung zu senken, ist es beispielsweise bekannt, Modulleiterplatten zu verwenden, auf denen Komponenten einer Spezialfunktion der Leiterplatte (z.B. spezielle Kommunikationsfunktion) angeordnet sind, während auf einer Basisleiterplatte die ansonsten identischen Komponenten vorhanden sind. Ein Teil der Basisleiterplatte wird freigelassen und die Modulleiterplatte wird wie ein SMD-Bauelement auf den freien Teil der Basisleiterplatte aufgelötet. Eine Modulleiterplatte der beschriebenen Art ist beispielsweise aus dem Datenblatt "WiMOD - iM240A: Datasheet Version V2.1" der IMST GmbH (Deutschland), Dokumentennummer 4100/6404/0011, vom 15.01.2009 bekannt (abgerufen im Internet unter http://www.wireless-solutions.de/wirelesssolutions/de/support/hardwaredokumente/iM240A/iM240A Datasheet V2 1.pdf). Hierdurch ist es möglich, eine gleichbleibende Basisleiterplatte je nach Anforderung flexibel mit unterschiedlichen Modulleiterplatten zu bestücken; außerdem können auch Leiterplatten unterschiedlicher Eigenschaften miteinander kombiniert werden.

Wie bereits erläutert benötigt die bekannte Bauweise auf der Basisleiterplatte eine freie Fläche an der Stelle, wo die Modulleiterplatte aufgebracht werden soll. Die Modulleiterplatte darf ihrerseits nur einseitig und nur in Oberflächenmontage (z.B. mit SMD-Bauteilen) bestückt werden, eine THT-Bestückung ("Through the hole" - Durchsteckmontage) ist hingegen nicht möglich. Während des Reflow-Lötprozesses zum Auflöten der Modulleiterplatte auf die Basisleiterplatte werden die auf der Modulleiterplatte vorhandenen Komponenten zudem einem zweiten thermischen Stress ausgesetzt. Außerdem ist eine gemeinsame Verarbeitung der beiden Leiterplatten, z.B. in einem einzigen Bestückungsprozess, nur mit großem Aufwand realisierbar.

Der Erfindung liegt daher die Aufgabe zugrunde, eine Basisleiterplatte sowie eine Modulleiterplatte anzugeben, die zu einer Leiterplattenanordnung kombiniert werden können und die eine vergleichsweise hohe Flexibilität bezüglich ihrer Fertigung, Verarbeitung und Bestückung bereitstellen.

Zur Lösung der Aufgabe bezüglich der Basisleiterplatte wird bei einer Basisleiterplatte der eingangs genannten Art vorgeschlagen, dass zur Ausbildung des mindestens einen federnden Elementes Ausfräsungen in zumindest einem Randbereich der Modulleiterplatte vorgesehen sind und die Ausfräsungen schlitzartig ausgebildet sind, wobei sich zwei Ausfräsungen in einer zur Außenkante der Modulleiterplatte parallelen Linie unter Belassen eines innenliegenden Stegbereiches erstrecken und sich eine weitere zu den anderen Ausfräsungen parallel beabstandete Ausfräsung im Bereich des Stegbereiches unter Belassen zweier außenliegender Randstege erstreckt.

Durch die beschriebene Ausgestaltung der Basisleiterplatte wird es ermöglicht, dass eine Modulleiterplatte nicht wie bei einer Ausführung des Standes der Technik auf die Basisleiterplatte aufgebracht wird, sondern stattdessen in die Aussparung der Basisleiterplatte eingesetzt wird. Hierzu weist die Basisleiterplatte eine entsprechende Aussparung auf, die zum Einfügen der Modulleiterplatte ausgebildet ist. Diese Aussparung kann bezüglich ihrer Formgebung beliebig, beispielsweise quadratisch, rechteckig oder mehreckig (z.B. L-förmig), ausgebildet sein. Die beschriebene Anordnung hat unter anderem die Vorteile, dass die Bestückungstechnik der Modulleiterplatte beliebig gewählt werden kann, insbesondere ist es erlaubt, die Modulleiterplatte von beiden Seiten mit Komponenten zu bestücken und dadurch die Bestückungsdichte quasi zu verdoppeln. Auch eine THT-Bestückung ist im Unterschied zum Stand der Technik möglich. Die Modulleiterplatte kann beispielsweise in einem separaten Fertigungsschritt erzeugt werden, erlaubt aber nach dem Einbringen in die Basisleiterplatte durch die dann ebene Ausgestaltung der hierdurch gebildeten Leiterplattenanordnung eine Weiterverarbeitung wie sie auch bei einer homogenen (nicht kombinierten) Leiterplatte durchgeführt werden könnte. Alternativ können die Basisleiterplatte und die Modulleiterplatte auch erst unbestückt oder teilbestückt zusammengefügt und dann in einem gemeinsamen Bestückungsprozess weiterverarbeitet werden. Darüber hinaus kann durch die kombinierte Bauweise eine flexible Auswahl von Modulleiterplatten zur Ausbildung unterschiedlicher Varianten einer Leiterplattenanordnung mit einer ansonsten gleichbleibenden Basisleiterplatte erfolgen. Die Basisleiterplatte und die Modulleiterplatte können unabhängig voneinander gefertigt und getestet werden, so dass nach dem Zusammenfügen keine erneuten aufwändigen Tests, insbesondere mechanische Tests (z.B. Rütteltest) oder thermische Tests (z.B. Test einer Temperaturbeständigkeit) mehr durchgeführt werden müssen.

Erfindungsgemäß ist vorgesehen, dass die Aussparung der Basisleiterplatte zum Herstellen einer Klemmverbindung mit der Modulleiterplatte eingerichtet ist.

Auf diese Weise lässt sich eine relativ einfache, aber dennoch stabile mechanische Verbindung der beiden Leiterplatten realisieren.

Konkret ist in diesem Zusammenhang vorgesehen, dass zum Herstellen der Klemmverbindung die Aussparung der Basisleiterplatte mindestens an einer Innenkante mindestens ein federndes Element aufweist, das derart ausgebildet ist, dass es bei eingefügter Modulleiterplatte eine Klemmkraft gegen eine entsprechende Außenkante der Modulleiterplatte ausübt.

Auf diese Weise lässt sich die Klemmverbindung vergleichsweise einfach herstellen, da zum Einfügen der Modulleiterplatte lediglich eine Kraft auf das mindestens eine federnde Element entgegen dessen Klemmrichtung aufgebracht werden muss und nach dem Einsetzen der Modulleiterplatte die Klemmkraft durch Entspannen des Federelementes gegen die Außenkante der Modulleiterplatte wirkt und damit die Modulleiterplatte in der Aussparung einklemmt.

Erfindungsgemäß ist vorgesehen, dass die Basisleiterplatte zum Herstellen einer Klemmverbindung in der Aussparung der Leiterplatte eingerichtet ist.

Konkret ist hierzu vorgesehen, dass zum Herstellen der Klemmverbindung die Basisleiterplatte mindestens an einer Außenkante mindestens ein federndes Element aufweist, das derart ausgebildet ist, dass es bei in die Aussparung der Leiterplatte eingefügter Basisleiterplatte eine Klemmkraft gegen eine entsprechende Innenkante der Aussparung ausübt.

Hierzu ist vorgesehen, dass zur Ausbildung des mindestens einen federnden Elementes Ausfräsungen in zumindest einem Randbereich der Basisleiterplatte vorgesehen sind.

Konkret ist vorgesehen, dass die Ausfräsungen schlitzartig ausgebildet sind, wobei sich zwei Ausfräsungen in einer zur Außenkante der Basisleiterplatte parallelen Linie unter Belassen eines innenliegenden Stegbereiches erstrecken und sich eine weitere zu den anderen Ausfräsungen parallel beabstandete Ausfräsung im Bereich des Stegbereiches unter Belassen zweier außenliegender Randstege erstreckt.

Eine vorteilhafte Ausführungsform der erfindungsgemäßen Basisleiterplatte sieht vor, dass entlang zumindest einer Innenkante der zumindest einen Aussparung Kontaktelemente angeordnet sind, die zur elektrischen Kontaktierung von an einer Außenkante der Modulleiterplatte vorgesehenen Kontaktelementen ausgebildet sind.

Hierdurch kann eine einfache und effektive elektrische Kontaktierung der Modulleiterplatte erfolgen. Je nach Anzahl der zwischen der Basisleiterplatte und der Modulleiterplatte zu erzeugenden elektrischen Verbindungen können Kontaktelemente an einer, mehreren oder allen Innenkanten der Aussparung vorgesehen sein. Die Kontaktelemente dienen neben der elektrischen Verbindung bevorzugt auch für eine mechanische Verbindung zwischen der Basisleiterplatte und der Modulleiterplatte.

Die Kontaktelemente können z.B. als separate Leitungen oder Bauteile ausgeführt sein, die nach dem Zusammenfügen der Basisleiterplatte und der Modulleiterplatte mit entsprechenden Kontaktelementen der Modulleiterplatte verbunden werden. Auch eine Ausbildung der Kontaktelemente in Form von Steckverbindungen oder sogenannten Jumpern ist möglich.

Als besonders vorteilhaft wird es jedoch angesehen, wenn die Kontaktelemente der Basisleiterplatte derart ausgebildet sind, dass sie mit entsprechenden Kontaktelementen der Modulleiterplatte unmittelbar über eine Lotverbindung verbindbar sind.

Bei der letztgenannten Ausführungsform kann die elektrische und die mechanische Verbindung in einem einfachen und leicht automatisierbaren Fertigungsschritt, nämlich durch ein Lötverfahren, erzeugt werden.

Konkret kann bezüglich der Kontaktelemente vorgesehen sein, dass die Kontaktelemente in Form von in die Fläche der Basisleiterplatte hineinragenden bogenförmigen Einfräsungen ausgebildet sind. Bevorzugt weisen die Kontaktelemente eine Halbkreisform auf.

Hierdurch kann die elektrische Verbindung, z.B. durch ein Lötverfahren, besonders einfach erfolgen, da sich das Lot in die bogen- bzw. halbkreisförmigen Kontaktelemente quasi selbstständig hereinzieht. Hierbei wird z.B. ein aus zwei gegenüberliegenden Kontaktelementen gebildetes Loch, das vorzugsweise einen metallisierten Rand aufweist, während des Lötprozesses (z.B. im Reflow-, Schwall- oder Tauchverfahren) mit Lot geflutet. Außerdem sind bogen- bzw. halbkreisförmige Einfräsungen beim Herstellen der Basisleiterplatte leicht zu erzeugen, beispielsweise indem zunächst Bohrungen im Randbereich der Basisleiterplatte eingebracht werden, die anschließend zur Bildung der bogenförmigen bzw. halbkreisförmigen Kontaktelemente in geeigneter Weise, z.B. mittig, durchfräst werden.

Um die mechanische Stabilität der Verbindung zwischen der Basisleiterplatte und der Modulleiterplatte zu erhöhen kann zudem vorgesehen sein, dass zumindest ein Kontaktelement vorgesehen ist, das größer als die übrigen an derselben Innenkante der Aussparung angeordneten Kontaktelemente ausgebildet ist.

Damit kann dieses Kontaktelement beim Verbinden der beiden Leiterplatten vergleichsweise mehr Lötzinn aufnehmen und zur Verbesserung der mechanischen Stabilität der Verbindung beitragen.

Eine weitere vorteilhafte Ausführungsform der erfindungsgemäßen Basisleiterplatte sieht vor, dass die Kontaktelemente mit Leiterbahnen der Basisleiterplatte in elektrischer Verbindung stehen, die zu der Aussparung herangeführt sind.

Hierdurch kann eine elektrische Verbindung zwischen Komponenten der Basisleiterplatte und den Kontaktelementen - und damit bei eingesetzter Modulleiterplatte auch den dort angeordneten Komponenten - erfolgen.

Die Basisleiterplatte und die Modulleiterplatte können wie eingangs erläutert unterschiedliche Eigenschaften aufweisen. Beispielsweise kann gemäß einer vorteilshaften Ausgestaltung der erfindungsgemäßen Basisleiterplatte vorgesehen sein, dass die Basisleiterplatte eine ein- oder mehrschichtige Leiterplatte ist, wobei die Anzahl der Schichten der Basisleiterplatte von der Anzahl von Schichten der aufzunehmenden Modulleiterplatte verschieden ist. Alternativ oder zusätzlich kann beispielsweise auch vorgesehen sein, dass die Basisleiterplatte eine Oberflächenbeschichtung oder eine Bestückungsart aufweist, die von einer Oberflächenbeschichtung oder einer Bestückungsart der Modulleiterplatte verschieden ist.

Hierdurch können die Kosten für eine aus der Basisleiterplatte und der Modulleiterplatte zusammengesetzte Leiterplattenanordnung insgesamt reduziert werden, da es ermöglicht wird, eine vergleichsweise aufwändige Herstellungstechnologie, z.B. zur Erzeugung mehrerer Schichten oder einer speziellen Oberflächenbeschichtung, auf eine der beiden Leiterplatten zu beschränken und die andere Leiterplatte vergleichsweise einfacher aufzubauen.

Die oben genannte Aufgabe wird zudem hinsichtlich der Modulleiterplatte durch eine Modulleiterplatte der eingangs genannten Art gelöst, bei der zur Ausbildung des mindestens einen federnden Elementes Ausfräsungen in zumindest einem Randbereich der Modulleiterplatte vorgesehen sind und die Ausfräsungen schlitzartig ausgebildet sind, wobei sich zwei Ausfräsungen in einer zur Außenkante der Modulleiterplatte parallelen Linie unter Belassen eines innenliegenden Stegbereiches erstrecken und sich eine weitere zu den anderen Ausfräsungen parallel beabstandete Ausfräsung im Bereich des Stegbereiches unter Belassen zweier außenliegender Randstege erstreckt.

Hinsichtlich der Vorteile der erfindungsgemäßen Modulleiterplatte wird im Wesentlichen auf die bereits zur erfindungsgemäßen Basisleiterplatte erläuterten Vorteile verwiesen, sofern nachfolgend nichts Abweichendes beschrieben wird, gelten diese Ausführungen in entsprechender Weise auch für die erfindungsgemäße Modulleiterplatte. Ebenso gelten die nachfolgenden Ausführungen in entsprechender Weise auch für die Basisleiterplatte.

Erfindungsgemäß ist vorgesehen, dass die Modulleiterplatte zum Herstellen einer Klemmverbindung in der Aussparung der Leiterplatte eingerichtet ist.

Konkret ist hierzu vorgesehen, dass zum Herstellen der Klemmverbindung die Modulleiterplatte mindestens an einer Außenkante mindestens ein federndes Element aufweist, das derart ausgebildet ist, dass es bei in die Aussparung der Leiterplatte eingefügter Modulleiterplatte eine Klemmkraft gegen eine entsprechende Innenkante der Aussparung ausübt.

Hierzu ist vorgesehen, dass zur Ausbildung des mindestens einen federnden Elementes Ausfräsungen in zumindest einem Randbereich der Modulleiterplatte vorgesehen sind.

Dadurch werden für die federnden Elemente keine separaten Bauteile benötigt, sondern das federnde Element wird durch Einbringen geeigneter Ausfräsungen direkt aus der Modulleiterplatte selbst ausgeformt.

Konkret ist vorgesehen, dass die Ausfräsungen schlitzartig ausgebildet sind, wobei sich zwei Ausfräsungen in einer zur Außenkante der Modulleiterplatte parallelen Linie unter Belassen eines innenliegenden Stegbereiches erstrecken und sich eine weitere zu den anderen Ausfräsungen parallel beabstandete Ausfräsung im Bereich des Stegbereiches unter Belassen zweier außenliegender Randstege erstreckt.

Dadurch kann in vergleichsweise einfacher Weise, nämlich durch Einbringen lediglich dreier schlitzartiger Ausfräsungen, ein federndes Element aus dem Material der Modulleiterplatte ausgeformt werden.

Generell können federnde Elemente an einer oder mehreren Außenkanten der Modulleiterplatte vorgesehen sein. Beim Vorsehen von mehreren federnden Elementen wird es zudem als vorteilhaft angesehen, wenn an zwei über Eck liegenden Außenkanten der Modulleiterplatte federnde Elemente angeordnet sind.

Bei dieser Ausführungsform lässt sich die Modulleiterplatte nämlich vergleichsweise einfach in die Aussparung der Basisleiterplatte einsetzen und dort verklemmen.

Um das Einsetzen der Modulleiterplatte in die Aussparung der Basisleiterplatte zu vereinfachen, kann außerdem gemäß einer weiteren vorteilhaften Ausführungsform vorgesehen sein, dass die Modulleiterplatte im Bereich eines federnden Elementes Montagemittel aufweist, die zum Zusammenwirken mit einem Montagewerkzeug, mit dem ein Vorspannen des federnden Elementes bewirkbar ist, eingerichtet sind.

Bei den Montagemitteln kann es sich beispielsweise um Bohrungen handeln (denkbar wären z.B. auch geeignete Haken oder Ösen), an denen ein beispielsweise zangenartig ausgebildetes Montagewerkzeug angreifen kann, um in einfacher Weise ein Vorspannen des federnden Elementes entgegen seiner Klemmrichtung zu bewirken. Nach dem Einsetzen der Modulleiterplatte in die Basisleiterplatte kann das an den Montagemitteln angreifende Montagewerkzeug das federnde Element wieder freigeben, um die Modulleiterplatte auf diese Weise in der Basisleiterplatte zu verklemmen.

Gemäß einer weiteren vorteilhaften Ausführungsform der erfindungsgemäßen Modulleiterplatte ist vorgesehen, dass entlang zumindest einer Außenkante der Modulleiterplatte Kontaktelemente angeordnet sind, die zur elektrischen Kontaktierung von an einer Innenkante der Aussparung der Basisleiterplatte vorgesehenen Kontaktelementen ausgebildet sind.

Konkret kann in diesem Zusammenhang beispielsweise vorgesehen sein, dass die Kontaktelemente der Modulleiterplatte derart ausgebildet sind, dass sie mit entsprechenden Kontaktelementen der Basisleiterplatte unmittelbar über eine Lotverbindung verbindbar sind.

Hinsichtlich der Kontaktelemente kann beispielsweise vorgesehen sein, dass die Kontaktelemente in Form von in die Fläche der Modulleiterplatte hineinragenden bogenförmigen Einfräsungen ausgebildet sind. Konkret kann z.B. vorgesehen sein, dass die Kontaktelemente eine Halbkreisform aufweisen.

Zur Erhöhung der mechanischen Stabilität der Verbindung kann die Modulleiterplatte zudem derart weitergebildet sein, dass zumindest ein Kontaktelement vorgesehen ist, das größer als die übrigen an derselben Außenkante der Modulleiterplatte angeordneten Kontaktelemente ausgebildet ist.

Außerdem kann hinsichtlich der Kontaktelemente vorgesehen sein, dass die Kontaktelemente der Modulleiterplatte mit Leiterbahnen der Modulleiterplatte in elektrischer Verbindung stehen, die zu den Außenkanten der Modulleiterplatte herangeführt sind.

Gemäß einer weiteren vorteilhaften Ausführungsform der erfindungsgemäßen Modulleiterplatte kann zudem vorgesehen sein, dass die Modulleiterplatte eine oder mehrere Schichten aufweist, wobei die Anzahl der Schichten der Modulleiterplatte von der Anzahl von Schichten der die Modulleiterplatte aufnehmenden Basisleiterplatte verschieden ist, und/oder dass die Modulleiterplatte eine Oberflächenbeschichtung oder eine Bestückungsart aufweist, die von einer Oberflächenbeschichtung oder einer Bestückungsart der Basisleiterplatte verschieden ist.

Die oben genannte Aufgabe wird außerdem durch eine Leiterplattenanordnung mit einer Basisleiterplatte zur Aufnahme von elektrischen und/oder elektronischen Komponenten gelöst, wobei die Basisleiterplatte elektrische Leiterbahnen aufweist.

Erfindungsgemäß ist hinsichtlich der Leiterplattenanordnung vorgesehen, dass die Basisleiterplatte gemäß einem der Ansprüche 1 bis 8 ausgebildet ist und in die Basisleiterplatte zumindest eine Modulleiterplatte eingefügt ist, die gemäß einem der Ansprüche 9 bis 18 ausgebildet ist.

Hinsichtlich der Vorteile der erfindungsgemäßen Leiterplattenanordnung wird auf die bereits zu der erfindungsgemäßen Basisleiterplatte und der erfindungsgemäßen Modulleiterplatte erläuterten Vorteile verwiesen.

Hinsichtlich der Leiterplattenanordnung ist gemäß einer vorteilhaften Ausführungsform vorgesehen, dass die Basisleiterplatte und die Modulleiterplatte durch eine Klemmverbindung verbunden sind.

Gemäß einer weiteren vorteilhaften Ausführungsform der erfindungsgemäßen Leiterplattenanordnung kann zudem vorgesehen sein, dass die Basisleiterplatte und die Modulleiterplatte elektrisch unmittelbar über eine ihre jeweiligen Kontaktelemente verbindenden Lotverbindung verbunden sind.

Alternativ dazu kann jedoch auch vorgesehen sein, dass die Leiterplatte und die Modulleiterplatte elektrisch über ihre jeweiligen Kontaktelemente verbindende elektrische oder elektronische Komponenten verbunden sind.

Solche elektrischen oder elektronischen Komponenten können beispielsweise Kabel oder Drähte, Steckverbinder, Jumper, aber auch Bauteile, wie z.B. Widerstände, insbesondere sogenannte 0Ω-Widerstände, sein.

Hinsichtlich der Leiterplattenanordnung wird schließlich darauf hingewiesen, dass zur Bildung der Leiterplattenanordnung jede beliebige Kombination von voranstehend beschriebenen Basis- und Modulleiterplatten verwendet werden kann. Beispielsweise können federnde Elemente zur Ausübung einer Klemmwirkung entweder nur an der Basisleiterplatte oder nur an der Modulleiterplatte oder an beiden Leiterplatten vorgesehen sein. Entsprechend können Kontaktelemente entweder nur an einer oder an beiden Leiterplatten angeordnet sein; diese können gleichartig (z.B. als bogenförmige Einfräsungen) oder unterschiedlich ausgebildet sein. Die Basisleiterplatte und die Modulleiterplatte können zudem übereinstimmende oder unterschiedliche Eigenschaften, wie beispielsweise eine Anzahl von Schichten oder eine Oberflächenbeschichtung oder eine bei der Bestückung einzusetzende Bestückungstechnologie, aufweisen. In der Basisleiterplatte können zudem eine oder mehrere Aussparungen vorgesehen sein, um eine entsprechende Anzahl von Modulleiterplatten einsetzen zu können.

Mögliche Ausbildungen der Erfindung werden nachfolgend anhand von Ausführungsbeispielen näher erläutert. Hierzu zeigen
- Figur 1: eine schematisch dargestellte Basisleiterplatte mit zwei eingesetzten Modulleiterplatten;
- Figur 2: einen Teil einer Modulleiterplatte mit einem federnden Element zum Herstellen einer Klemmverbindung;
- Figur 3: der Teil der Modulleiterplatte aus Figur 2 mit vorgespanntem federnden Element;
- Figur 4: den Teil der Modulleiterplatte aus Figur 3 vor dem Einsetzen in eine Aussparung einer Basisleiterplatte;
- Figur 5: einen Teil einer aus einer Basisleiterplatte mit eingesetzter Modulleiterplatte gebildeten Leiterplattenanordnung;
- Figur 6: eine schematische Ansicht von Kontaktelementen;
- Figur 7: eine Modulleiterplatte mit über Eck angeordneten federnden Elementen;
- Figur 8: eine Basisleiterplatte mit einer Aussparung vor dem Einsetzen einer Modulleiterplatte; und
- Figur 9: eine Leiterplattenanordnung bestehend aus der Leiterplatte aus Figur 8 nach dem Einsetzen der Modulleiterplatte.

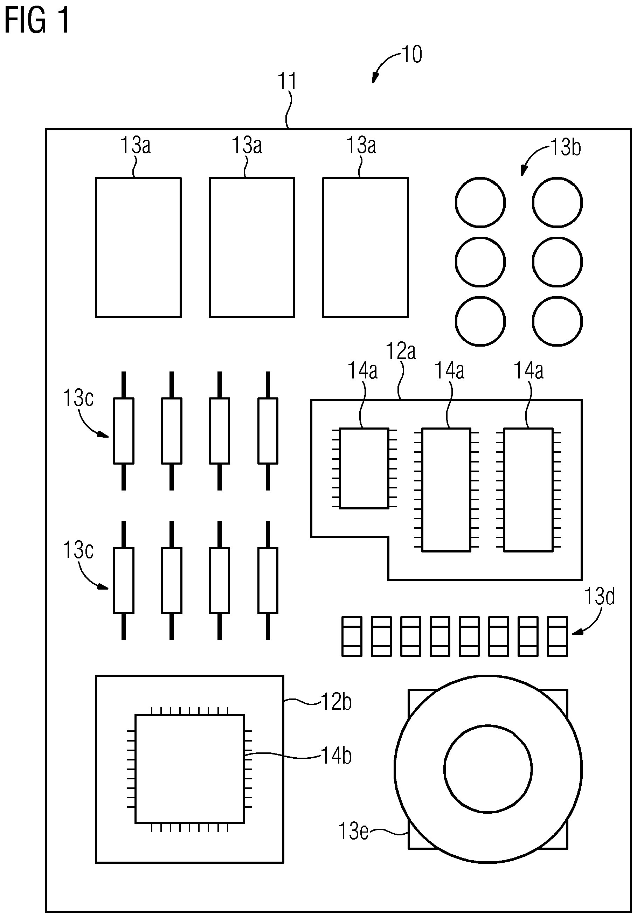

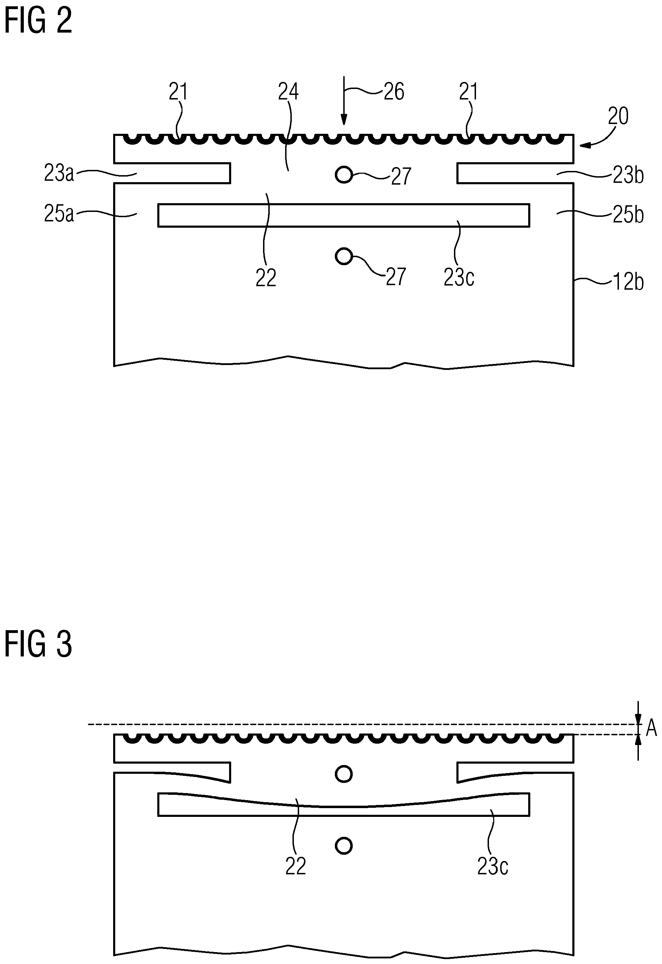

Figur 1 zeigt in schematischer Draufsicht eine Leiterplattenanordnung 10 mit einer Basisleiterplatte 11, in die zwei Modulleiterplatten 12a, 12b eingesetzt sind. Dazu weist die Basisleiterplatte 11 an den Stellen, an denen die Modulleiterplatten 12a-b eingesetzt werden, Aussparungen auf, die derart ausgebildet sind, dass sich die Modulleiterplatten 12a-b nach dem Einsetzen in derselben Ebene wie die Basisleiterplatte 11 befinden. Die Aussparungen können mit einer beliebigen Formgebung ausgeführt sein, beispielsweise quadratisch, rechteckig oder mehreckig (z.B. L-förmig wie die Aussparung für Modulleiterplatte 12a). Die jeweilige Modulleiterplatte 12a-b kann dabei beispielsweise locker in die entsprechende Aussparung eingesetzt und durch beliebige mechanische Haltemittel mit der Basisleiterplatte verbunden werden. Als besonders vorteilhaft wird es jedoch angesehen, wenn die jeweilige Modulleiterplatte 12a-b und die Basisleiterplatte 11 mittels einer Klemmverbindung miteinander verbunden werden. Diese Ausführungsform wird später anhand der Figuren 2-5 näher erläutert.

Bei dem Beispiel der Figur 1 ist die Basisleiterplatte 11 mit mehreren elektrischen und/oder elektronischen Komponenten 13a-e bestückt, die sich durch eine vergleichsweise niedrige Integrationsdichte und damit eine geringe Anzahl elektrischer Anschlüsse auszeichnen. Beispielsweise kann es sich bei den Komponenten 13a um elektromechanische Relais, bei den Komponenten 13b um Kondensatoren, bei den Komponenten 13a um Widerstände in THT-Bestückungsbauweise, bei den Komponenten 13d um SMD-Bauteile (z.B. Widerstände) und bei der Komponente 13e um eine Spule, z.B. eines Netzteils, handeln. Die Modulleiterplatten 12a, 12b sind hingegen mit elektrischen und/oder elektronischen Komponenten 14a, 14b einer hohen Integrationsdichte bestückt, im Beispiel der Figur 1 ist die Modulleiterplatte 12a beispielsweise mit Speicherbausteinen 14a und die Modulleiterplatte 12b mit einem Prozessor 14b bestückt.

Die Komponenten 13a-e und 14a-b richten unterschiedliche Anforderungen an die sie tragenden Leiterplatten, beispielsweise kann es die hohe Anzahl elektrisch zu verbindender Anschlüsse der Komponenten 14a-b mit hoher Integrationsdichte erforderlich machen, die Modulleiterplatten als mehrschichtige Leiterplatten (Multilayer mit z.B. 12-14 Schichten) auszuführen, wobei jede Schicht eigene Leiterbahnen zur elektrischen Verbindung eines Teils der Anschlüsse der Komponenten 14a-b führt, während für die Komponenten 13a-e eine Leiterplatte mit einer oder wenigen (z.B. 2-4) Schichten ausreicht. Würde man die komplette Leiterplattenanordnung 10 als homogene, d.h. einstückige Leiterplatte ausbilden, so müsste sie, um auch den Anforderungen der Komponenten 14a-b gerecht zu werden, überall als entsprechend mehrschichtige Leiterplatte ausgebildet sein, was zu entsprechend hohen Kosten der Leiterplattenanordnung führen würde. Daher ist gemäß der in Figur 1 dargestellten Leiterplattenanordnung 10 vorgesehen, dass die Basisleiterplatte 11 Aussparungen aufweist, in die die Modulleiterplatten 12a, 12b eingesetzt werden können. Auf diese Weise ist es möglich, lediglich die Modulleiterplatten 12a, 12b mit einer hohen Schichtenanzahl auszubilden, während die Basisleiterplatte mit einer deutlich geringeren Schichtenanzahl auskommt. Hierdurch sinken die Kosten für die Leiterplattenanordnung im Vergleich zu einer homogen ausgebildeten Leiterplatte signifikant, da die zusätzlich entstehenden Kosten für das Einbringen der Aussparung in der Basisleiterplatte 11 und die entsprechende Ausführung der Modulleiterplatten 12a und 12b durch die Einsparungen aufgrund der einfacheren Ausführung der Basisleiterplatte 11 überkompensiert werden.

Die obigen Ausführungen beziehen sich lediglich beispielhaft auf eine Leiterplattenanordnung mit Leiterplatten unterschiedlicher Schichtenanzahl. Alternativ oder zusätzlich können auch andere Gründe für eine kombinierte Leiterplattenanordnung sprechen, z.B. unterschiedliche Oberflächenbeschichtungen oder Bestückungs- oder Herstellungstechnologien der Leiterplatten. Auch eine Bestückung von Modulleiterplatten mit mehreren Varianten von eine spezielle Funktion ausübenden Komponenten (z.B. verschiedene Varianten einer Kommunikationsbaugruppe) ist möglich; eine ansonsten gleichbleibende Basisleiterplatte kann dann durch entsprechendes Einsetzen einer der Modulleiterplatten-Varianten an einen entsprechenden Kundenwunsch angepasst werden.

Um die auf der jeweiligen Modulleiterplatte 12a-b vorgesehenen Komponenten mit den auf der Basisleiterplatte vorgesehenen Komponenten elektrisch zu verbinden, weisen sowohl die Basisleiterplatte 11 als auch die jeweilige Modulleiterplatte 12a-b geeignete Kontaktelemente auf. Diese sind in Figur 1 der Übersichtlichkeit halber nicht dargestellt und werden anhand der nachfolgenden Figuren näher erläutert. Als Kontaktelemente können beispielsweise separate Bauteile, wie z.B. elektrische Drähte oder Kabel, Steckverbinder oder Jumper oder auf der Stoßkante zwischen Basisleiterplatte 11 und der jeweiligen Modulleiterplatte 12a-b angeordnete elektrische Bauteile (z.B. Widerstände, insbesondere 0Ω-Widerstände) verwendet werden. Alternativ dazu können die Kontaktelemente jedoch auch an einer oder mehreren Außenkanten der jeweiligen Modulleiterplatte 12a-b und entsprechenden Innenkanten der Aussparungen in der Basisleiterplatte 11 angeordnet sein und beispielsweise als Einfräsungen ausgebildet sein. Solchermaßen ausgebildete Kontaktelemente können nach dem Einsetzen der jeweiligen Modulleiterplatte 12a-b in die Basisleiterplatte 11 mittels einer direkten Lötverbindung miteinander verbunden werden und auf diese Weise gleichermaßen eine elektrische wie eine mechanische Verbindung zwischen den jeweiligen Leiterplatten herstellen.

Anhand der Figuren 2 bis 5 soll nachfolgend an einem Ausführungsbeispiel einer Modulleiterplatte die Herstellung einer Leiterplattenanordnung näher erläutert werden. Dies soll anhand des Beispiels der Modulleiterplatte 12b gezeigt werden.

Hierzu ist zunächst in Figur 2 ein Ausschnitt der ansonsten nur schematisch dargestellten Modulleiterplatte 12b gezeigt.

Die Modulleiterplatte 12b weist an einer Außenkante 20 mehrere Kontaktelemente 21 auf, die als an ihren Rändern metallisierte, bogen bzw. halbkreisförmige Einfräsungen in die Modulleiterplatte 12b ausgebildet sind. Anstelle einer bogen- bzw. halbkreisförmigen Ausbildung kann auch jede beliebige andere Formgebung gewählt werden, allerdings bietet die bogen- bzw. halbkreisförmige Ausgestaltung den Vorteil einer einfachen Fertigung mit gängigen Werkzeugen.

Zum Ausbilden einer Klemmverbindung weist die Modulleiterplatte 12b darüber hinaus an der Außenkante 20 ein federndes Element 22 auf, das im Beispiel der Figur 2 direkt aus der Modulleiterplatte 12b ausgeformt worden ist. Dafür wurden entsprechende schlitzartige Ausfräsungen in die Modulleiterplatte 12b eingebracht, wobei sich zwei Ausfräsungen 23a, 23b in einer zur Außenkante 20 der Modulleiterplatte 12b parallelen Linie unter Belassen eines innenliegenden Stegbereiches 24 erstrecken und sich eine weitere zu den beiden Ausfräsungen 23a, 23b parallel beabstandete Ausfräsung 23c im Bereich des Stegbereiches 24 unter Belassen zweier außenliegender Randstege 25a, 25b erstreckt. Hierdurch wird in konstruktiv einfacher Weise direkt aus dem Material der Modulleiterplatte 12b ein federndes Element 22 ausgeformt, das durch Ausüben einer Kraft in Richtung des Pfeiles 26 vorgespannt werden kann und dieser Richtung eine Klemmkraft entgegensetzt.

Zur Anbindung der Kontaktelemente 21 an auf der Modulleiterplatte 12b vorhandene elektrische und/oder elektronische Komponenten sind im Bereich des Stegbereiches 24 und der Randstege 25a-b in geeigneter Weise Leiterbahnen zu führen. Diese sind in Figur 2 der Übersichtlichkeit halber jedoch nicht dargestellt. Außerdem müssen sich die Kontaktelemente 21 nicht zwingend an derselben Außenkante befinden, an der auch das federnde Element 22 ausgebildet ist, vielmehr kann jede beliebige andere Außenkante für die Kontaktelemente gewählt werden.

Zum einfacheren Ausüben der für das Vorspannen des federnden Elementes 22 nötigen Kraft befinden sich in dessen Bereich Montagemittel 27, die in dem Ausführungsbeispiel der Figur 2 in Form zweier Bohrungen ausgebildet sind. In diese kann ein Montagewerkzeug, z.B. eine entsprechend ausgebildete Zange, eingreifen und das federnde Element entsprechend vorspannen.

Figur 3 zeigt die Modulleiterplatte 12b der Figur 2 im vorgespannten Zustand. Man erkennt, dass durch entsprechende elastische Verformung des federnden Elementes 22, insbesondere im Bereich der Ausfräsung 23c, das federnde Element 22 um eine Strecke A im Vergleich zu seiner entspannten Lage eingedrückt worden ist.

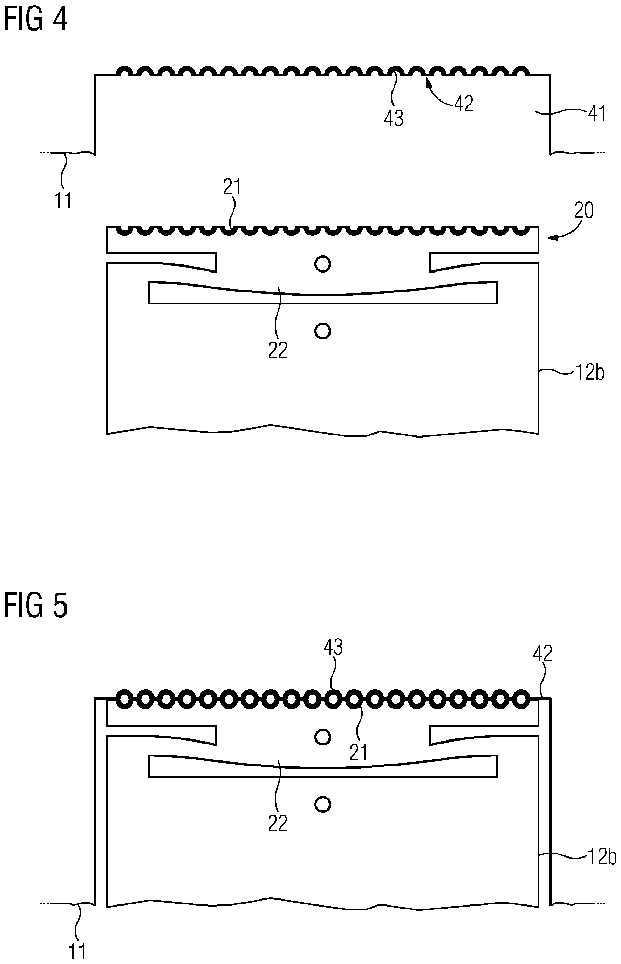

Wie Figur 4 entnommen werden kann, wird daraufhin die Modulleiterplatte 12b mit dem entsprechend vorgespannten federnden Element 22 in die vorgesehene Aussparung 41 in der in Figur 4 nur schematisch angedeuteten Basisleiterplatte 11 eingesetzt. Die Basisleiterplatte 11 weist an einer der Außenkante 20 gegenüberliegenden Innenkante 42 der Aussparung 41 den Kontaktelementen 21 der Modulleiterplatte 21 entsprechende Kontaktelemente 43 auf, die ebenfalls in Form von metallisierten bogen- bzw. halbkreisförmigen Einfräsungen ausgebildet sind.

Figur 5 zeigt die Modulleiterplatte 12b im in die Basisleiterplatte 11 eingesetzten Zustand, das federnde Element 22 kann sich unter Ausüben einer Klemmkraft in Richtung der entsprechenden Innenkante 51 der Aussparung etwas entspannen. Es entsteht eine Klemmverbindung zwischen der Modulleiterplatte 12b und der Basisleiterplatte 11. In einem anschließenden Schritt können die Kontaktelemente 21 und 43 der Modulleiterplatte 12b und der Basisleiterplatte 11 durch eine Lötverbindung miteinander elektrisch und mechanisch verbunden werden.

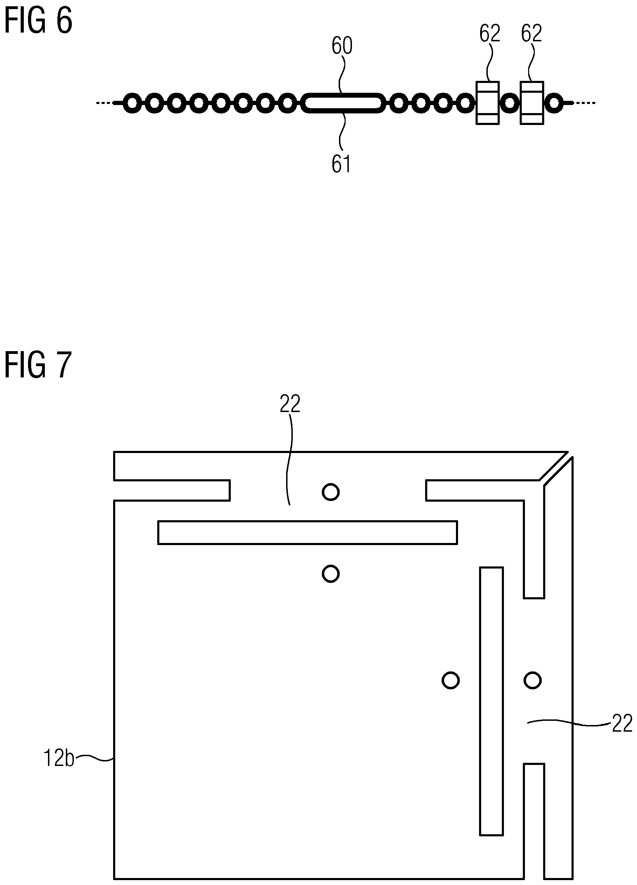

Um die mechanische Stabilität der Verbindung noch weiter zu erhöhen, kann zudem vorgesehen sein, das zumindest eine der Einfräsungen 60, 61 auf beiden Leiterplatten entsprechend breiter ausgebildet ist als die anderen Einfräsungen, wie beispielhaft in Figur 6 angedeutet ist. Da diese breiteren Einfräsungen 60, 61 entsprechend mehr Lot aufnehmen kann, wird hierbei eine stabilere Verbindung geschaffen. Alternativ oder zusätzlich dazu kann eine Erhöhung der mechanischen Stabilität der Verbindung auch durch das Auflöten von elektrischen oder elektronischen Bauteilen, z.B. 0Ω-Widerständen 62 in SMD-Bauweise, erreicht werden.

Die beschriebenen federnden Elemente 22 (vgl. z.B. Figur 2) können an einer oder mehreren Außenkanten der Modulleiterplatte 12b angeordnet sein. Figur 7 zeigt beispielhaft eine Ausführungsform der Modulleiterplatte 12b mit zwei über Eck angeordneten federnden Elementen 22.

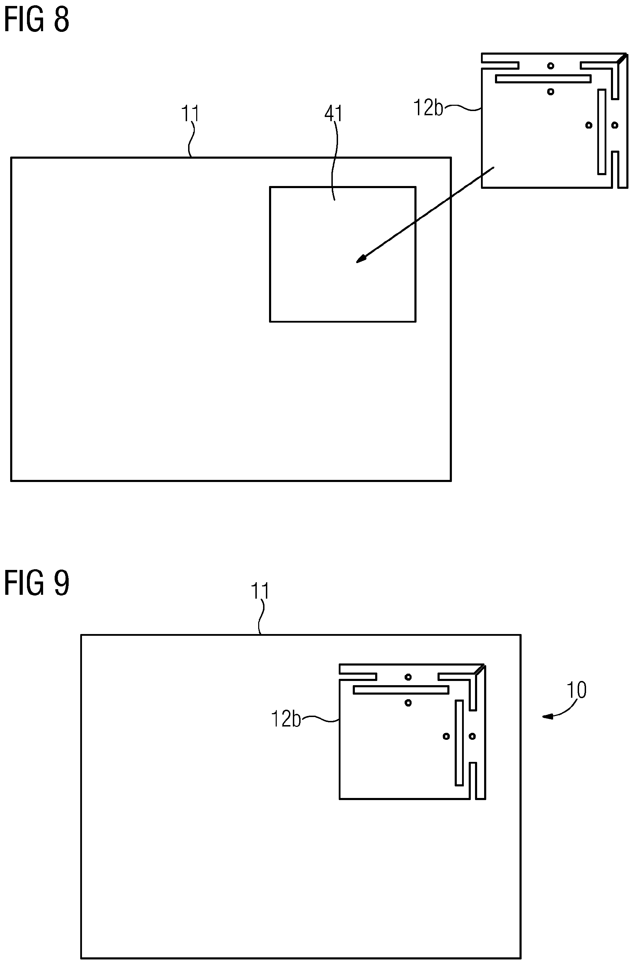

Figuren 8 und 9 zeigen schließlich schematisch das Einfügen einer solchermaßen ausgebildeten Modulleiterplatte 12b in eine entsprechende Aussparung 41 der Basisleiterplatte 11. Die Abmessungen der Aussparung sollten derart bemessen sein, dass eine Klemmverbindung mit der Modulleiterplatte 12b hergestellt werden kann. Hierzu sollte das Innenmaß des Aussparung 41 etwas kleiner ausgeführt sein als das Außenmaß der Modulleiterplatte 12b im entspannten Zustand. Figur 9 zeigt schließlich die durch die in die Basisleiterplatte 11 eingesetzte Modulleiterplatte 12b gebildete Leiterplattenanordnung 10.

Da Basisleiterplatte 11 und Modulleiterplatte 12b sich in derselben Ebene erstrecken, kann die fertige Leiterplattenanordnung 10 wie eine homogene einstückig aufgebaute Leiterplatte weiterverarbeitet werden.

Obwohl bei den vorstehend beschriebenen Ausführungsbeispielen das federnde Element immer auf Seiten der Modulleiterplatte 12b angeordnet ist, kann es im Rahmen der Erfindung auch auf Seiten der Basisleiterplatte 11 oder auf beiden Seiten angeordnet sein.

## Patentansprüche

1. Basisleiterplatte (11) zur Aufnahme von elektrischen und/oder elektronischen Komponenten (13a-e), wobei die Basisleiterplatte (11) elektrische Leiterbahnen aufweist, wobei in der Basisleiterplatte (11) zumindest eine Aussparung (41) vorgesehen ist, die zur Aufnahme einer Modulleiterplatte (12a, 12b) in der Weise ausgebildet ist, dass bei in die Aussparung (41) eingefügter Modulleiterplatte (12a, 12b) diese mit der Basisleiterplatte (11) in einer Ebene angeordnet ist, wobei
- die Aussparung (41) der Basisleiterplatte (11) zum Herstellen einer Klemmverbindung mit der Modulleiterplatte (12a, 12b) eingerichtet ist, wobei zum Herstellen der Klemmverbindung die Aussparung (41) der Basisleiterplatte (11) mindestens an einer Innenkante (42) mindestens ein federndes Element aufweist, das derart ausgebildet ist, dass es bei eingefügter Modulleiterplatte (12a, 12b) eine Klemmkraft gegen eine entsprechende Außenkante (20) der Modulleiterplatte (12a, 12b) ausübt,
- zur Ausbildung des mindestens einen federnden Elementes (22) Ausfräsungen (23a-c) in zumindest einem Randbereich der Basisleiterplatte (11) vorgesehen sind und
- die Ausfräsungen (23a-c) schlitzartig ausgebildet sind;
**dadurch gekennzeichnet, dass**
- sich zwei Ausfräsungen (23a-b) in einer zur Außenkante (20) der Basisleiterplatte (11) parallelen Linie unter Belassen eines innenliegenden Stegbereiches (24) erstrecken und sich eine weitere zu den anderen Ausfräsungen (23a-b) parallel beabstandete Ausfräsung (23c) im Bereich des Stegbereiches (24) unter Belassen zweier außenliegender Randstege (25a-b) erstreckt.

2. Basisleiterplatte (11) nach Anspruch 1,
**dadurch gekennzeichnet, dass**
- entlang zumindest einer Innenkante (42) der zumindest einen Aussparung (41) Kontaktelemente (43) angeordnet sind, die zur elektrischen Kontaktierung von an einer Außenkante (20) der Modulleiterplatte (12b) vorgesehenen Kontaktelementen (21) ausgebildet sind.

3. Basisleiterplatte (11) nach Anspruch 2,
**dadurch gekennzeichnet, dass**
- die Kontaktelemente (43) der Basisleiterplatte (11) derart ausgebildet sind, dass sie mit entsprechenden Kontaktelementen (21) der Modulleiterplatte (12b) unmittelbar über eine Lotverbindung verbindbar sind.

4. Basisleiterplatte (11) nach Anspruch 2 oder 3,
- die Kontaktelemente (43) in Form von in die Fläche der Basisleiterplatte (11) hineinragenden bogenförmigen Einfräsungen ausgebildet sind.

5. Basisleiterplatte (11) nach Anspruch 4,
**dadurch gekennzeichnet, dass**
- die Kontaktelemente (43) eine Halbkreisform aufweisen.

6. Basisleiterplatte (11) nach Anspruch 4 oder 5,
- zumindest ein Kontaktelement (60) vorgesehen ist, das größer als die übrigen an derselben Innenkante (42) der Aussparung (41) angeordneten Kontaktelemente (43) ausgebildet ist.

7. Basisleiterplatte (11) nach einem der Ansprüche 2-6,
**dadurch gekennzeichnet, dass**
- die Kontaktelemente (43) mit Leiterbahnen der Basisleiterplatte (11) in elektrischer Verbindung stehen, die zu der Aussparung (41) herangeführt sind.

8. Basisleiterplatte (11) nach einem der vorangehenden Ansprüche,
**dadurch gekennzeichnet, dass**
- die Basisleiterplatte (11) eine ein- oder mehrschichtige Leiterplatte ist, wobei die Anzahl der Schichten der Basisleiterplatte (11) von der Anzahl von Schichten der aufzunehmenden Modulleiterplatte (12a, 12b) verschieden ist, und/oder dass
- die Basisleiterplatte (11) eine Oberflächenbeschichtung oder eine Bestückungsart aufweist, die von einer Oberflächenbeschichtung oder einer Bestückungsart der Modulleiterplatte (12a, 12b) verschieden ist.

9. Modulleiterplatte (12a, 12b) zur Aufnahme von elektrischen und/oder elektronischen Komponenten (14a, 14b), wobei die Modulleiterplatte (12a, 12b) elektrische Leiterbahnen aufweist, wobei die Modulleiterplatte (12a, 12b) dazu ausgebildet ist, in eine Aussparung (41) einer Basisleiterplatte (11) derart eingefügt zu werden, dass bei in die Aussparung (41) eingefügter Modulleiterplatte (12a, 12b) diese mit der Basisleiterplatte (11) in einer Ebene angeordnet ist, wobei
- die Modulleiterplatte (12a, 12b) zum Herstellen einer Klemmverbindung in der Aussparung (41) der Basisleiterplatte (11) eingerichtet ist, wobei zum Herstellen der Klemmverbindung die Modulleiterplatte (12a, 12b) mindestens an einer Außenkante (20) mindestens ein federndes Element (22) aufweist, das derart ausgebildet ist, dass es bei in die Aussparung (41) der Basisleiterplatte (11) eingefügter Modulleiterplatte (12a, 12b) eine Klemmkraft gegen eine entsprechende Innenkante (42) der Aussparung (41) ausübt;
**dadurch gekennzeichnet, dass**
- zur Ausbildung des mindestens einen federnden Elementes (22) Ausfräsungen (23a-c) in zumindest einem Randbereich der Modulleiterplatte (12a, 12b) vorgesehen sind und
- die Ausfräsungen (23a-c) schlitzartig ausgebildet sind, wobei sich zwei Ausfräsungen (23a-b) in einer zur Außenkante (20) der Modulleiterplatte (12a, 12b) parallelen Linie unter Belassen eines innenliegenden Stegbereiches (24) erstrecken und sich eine weitere zu den anderen Ausfräsungen (23a-b) parallel beabstandete Ausfräsung (23c) im Bereich des Stegbereiches (24) unter Belassen zweier außenliegender Randstege (25a-b) erstreckt.

10. Modulleiterplatte (12a, 12b) nach Anspruch 9,
**dadurch gekennzeichnet, dass**
- an zwei über Eck liegenden Außenkanten der Modulleiterplatte (12a, 12b) federnde Elemente (22) angeordnet sind.

11. Modulleiterplatte (12a, 12b) nach Anspruch 9 oder 10,
**dadurch gekennzeichnet, dass**
- die Modulleiterplatte (12a, 12b) im Bereich eines federnden Elementes (22) Montagemittel (27) aufweist, die zum Zusammenwirken mit einem Montagewerkzeug, mit dem ein Vorspannen des federnden Elementes (22) bewirkbar ist, eingerichtet sind.

12. Modulleiterplatte (12a, 12b) nach einem der Ansprüche 9-11,
**dadurch gekennzeichnet, dass**
- entlang zumindest einer Außenkante (20) der Modulleiterplatte (12a, 12b) Kontaktelemente (21) angeordnet sind, die zur elektrischen Kontaktierung von an einer Innenkante (42) der Aussparung (41) der Basisleiterplatte (11) vorgesehenen Kontaktelementen (43) ausgebildet sind.

13. Modulleiterplatte (12a, 12b) nach Anspruch 12,
**dadurch gekennzeichnet, dass**
- die Kontaktelemente (21) der Modulleiterplatte (12a, 12b) derart ausgebildet sind, dass sie mit entsprechenden Kontaktelementen (43) der Basisleiterplatte (11) unmittelbar über eine Lotverbindung verbindbar sind.

14. Modulleiterplatte (12a, 12b) nach Anspruch 12 oder 13,
- die Kontaktelemente (21) in Form von in die Fläche der Modulleiterplatte (12a, 12b) hineinragenden bogenförmigen Einfräsungen ausgebildet sind.

15. Modulleiterplatte (12a, 12b) nach Anspruch 14,
**dadurch gekennzeichnet, dass**
- die Kontaktelemente (21) eine Halbkreisform aufweisen.

16. Modulleiterplatte (12a, 12b) nach Anspruch 14 oder 15,
- zumindest ein Kontaktelement (61) vorgesehen ist, das größer als die übrigen an derselben Außenkante (20) der Modulleiterplatte (12a, 12b) angeordneten Kontaktelemente (21) ausgebildet ist.

17. Modulleiterplatte (12a, 12b) nach einem der Ansprüche 12-16,
**dadurch gekennzeichnet, dass**
- die Kontaktelemente (21) der Modulleiterplatte (12a, 12b) mit Leiterbahnen der Modulleiterplatte (12a, 12b) in elektrischer Verbindung stehen, die zu den Außenkanten (20) der Modulleiterplatte (12a, 12b) herangeführt sind.

18. Modulleiterplatte (12a, 12b) nach einem der Ansprüche 9-17,
**dadurch gekennzeichnet, dass**
- die Modulleiterplatte (12a, 12b) eine oder mehrere Schichten aufweist, wobei die Anzahl der Schichten der Modulleiterplatte (12a, 12b) von der Anzahl von Schichten der die Modulleiterplatte (12a, 12b) aufnehmenden Basisleiterplatte (11) verschieden ist, und/oder dass
- die Modulleiterplatte (12a, 12b) eine Oberflächenbeschichtung oder eine Bestückungsart aufweist, die von einer Oberflächenbeschichtung oder einer Bestückungsart der Basisleiterplatte (11) verschieden ist.

19. Leiterplattenanordnung (10) mit
- einer Basisleiterplatte (11) zur Aufnahme von elektrischen und/oder elektronischen Komponenten (13a-e), wobei die Basisleiterplatte (11) elektrische Leiterbahnen aufweist, wobei in der Basisleiterplatte (11) zumindest eine Aussparung (41) vorgesehen ist; und - einer Modulleiterplatte (12a, 12b) zur Aufnahme von elektrischen und/oder elektronischen Komponenten (14a, 14b), wobei die Modulleiterplatte (12a, 12b) elektrische Leiterbahnen aufweist; wobei
in die Aussparung (41) der Basisleiterplatte (11) die Modulleiterplatte (12a, 12b) eingefügt ist,
**dadurch gekennzeichnet, dass**
- die Basisleiterplatte (11) und die Modulleiterplatte (12a, 12b) durch eine Klemmverbindung verbunden sind; und
- die Modulleiterplatte (12a, 12b) gemäß einem der Ansprüche 9 bis 18 und/oder die Basisleiterplatte (11) nach einem der Ansprüche 1 bis 8 ausgebildet ist.

20. Leiterplattenanordnung (10) nach Anspruch 19,
**dadurch gekennzeichnet, dass**
- die Basisleiterplatte (11) und die Modulleiterplatte (12a, 12b) elektrisch unmittelbar über eine ihre jeweiligen Kontaktelemente (21, 43) verbindenden Lotverbindung verbunden sind.

21. Leiterplattenanordnung (10) nach Anspruch 20,
**dadurch gekennzeichnet, dass**
- die Basisleiterplatte (11) und die Modulleiterplatte (12a, 12b) elektrisch über ihre jeweiligen Kontaktelemente (21, 43) verbindende elektrische oder elektronische Komponenten (62) verbunden sind.

## Claims

1. Base printed circuit board (11) for receiving electrical and/or electronic components (13a-e), wherein the base printed circuit board (11) has electrical conductor tracks, wherein at least one cutout (41) is provided in the base printed circuit board (11), which cutout is designed to receive a module printed circuit board (12a, 12b) in such a way that, when a module printed circuit board (12a, 12b) is inserted into the cutout (41), the said module printed circuit board is arranged in one plane with the base printed circuit board (11), wherein
- the cutout (41) in the base printed circuit board (11) is designed to establish a clamping connection with the module printed circuit board (12a, 12b), wherein, for the purpose of establishing the clamping connection, the cutout (41) in the base printed circuit board (11) has at least one resilient element at least on an inner edge (42), which at least one resilient element is designed in such a way that, when the module printed circuit board (12a, 12b) is inserted, the said resilient element exerts a clamping force against a corresponding outer edge (20) of the module printed circuit board (12a, 12b),
- milled-out portions (23a-c) are provided in at least one edge region of the base printed circuit board (11) for the purpose of forming the at least one resilient element (22), and
- the milled-out portions (23a-c) are of slot-like design;
**characterized in that**
- two milled-out portions (23a-b) extend in a line which is parallel to the outer edge (20) of the base printed circuit board (11) so as to leave an internal web region (24), and a further milled-out portion (23c), which is at a parallel distance from the other milled-out portions (23a-b), extends in the region of the web region (24) so as to leave two external edge webs (25a-b).

2. Base printed circuit board (11) according to Claim 1,
**characterized in that**
- contact elements (43) are arranged along at least one inner edge (42) of the at least one cutout (41), which contact elements are designed to make electrical contact with contact elements (21) which are provided on an outer edge (20) of the module printed circuit board (12b).

3. Base printed circuit board (11) according to Claim 2,
**characterized in that**
- the contact elements (43) of the base printed circuit board (11) are formed in such a way that they can be connected to corresponding contact elements (21) of the module printed circuit board (12b) directly by means of a solder connection.

4. Base printed circuit board (11) according to Claim 2 or 3,
**characterized in that**
- the contact elements (43) are designed in the form of arcuate milled portions which protrude into the surface of the base printed circuit board (11).

5. Base printed circuit board (11) according to Claim 4,
**characterized in that**
- the contact elements (43) have a semicircular shape.

6. Base printed circuit board (11) according to Claim 4 or 5,
**characterized in that**
- at least one contact element (60) is provided, which at least one contact element is designed to be larger than the other contact elements (43) which are arranged on the same inner edge (42) of the cutout (41).

7. Base printed circuit board (11) according to one of Claims 2-6,
**characterized in that**
- the contact elements (43) are electrically connected to conductor tracks of the base printed circuit board (11) which are led to the cutout (41).

8. Base printed circuit board (11) according to one of the preceding claims,
**characterized in that**
- the base printed circuit board (11) is a single- or multilayer printed circuit board, wherein the number of layers of the base printed circuit board (11) is different from the number of layers of the module printed circuit board (12a, 12b) which is to be received, and/or **in that**
- the base printed circuit board (11) has a surface coating or a type of equipment which is different from a surface coating or a type of equipment of the module printed circuit board (12a, 12b).

9. Module printed circuit board (12a, 12b) for receiving electrical and/or electronic components (14a, 14b), wherein the module printed circuit board (12a, 12b) has electrical conductor tracks, wherein the module printed circuit board (12a, 12b) is designed to be inserted into a cutout (41) in a base printed circuit board (11) in such a way that, when a module printed circuit board (12a, 12b) is inserted into the cutout (41), the said module printed circuit board is arranged in one plane with the base printed circuit board (11), wherein
- the module printed circuit board (12a, 12b) is designed to establish a clamping connection in the cutout (41) in the base printed circuit board (11), wherein, for the purpose of establishing the clamping connection, the module printed circuit board (12a, 12b) has at least one resilient element (22) at least on an outer edge (20), which at least one resilient element is designed in such a way that, when the module printed circuit board (12a, 12b) is inserted into the cutout (41) in the base printed circuit board (11), the said resilient element exerts a clamping force against a corresponding inner edge (42) of the cutout (41); **characterized in that**
- milled-out portions (23a-c) are provided in at least one edge region of the module printed circuit board (12a, 12b) for the purpose of forming the at least one resilient element (22), and
- the milled-out portions (23a-c) are of slot-like design, wherein two milled-out portions (23a-b) extend in a line which is parallel to the outer edge (20) of the module printed circuit board (12a, 12b) so as to leave an internal web region (24), and a further milled-out portion (23c), which is at a parallel distance from the other milled-out portions (23a-b), extends in the region of the web region (24) so as to leave two external edge webs (25a-b).

10. Module printed circuit board (12a, 12b) according to Claim 9,
**characterized in that**
- resilient elements (22) are arranged on two outer edges of the module printed circuit board (12a, 12b) which are situated around a corner.

11. Module printed circuit board (12a, 12b) according to Claim 9 or 10,
**characterized in that**
- the module printed circuit board (12a, 12b) has mounting means (27) in the region of a resilient element (22), which mounting means are designed to interact with a mounting tool with which the resilient element (22) can be pretensioned.

12. Module printed circuit board (12a, 12b) according to one of Claims 9-11,
**characterized in that**
- contact elements (21) are arranged along at least one outer edge (20) of the module printed circuit board (12a, 12b), which contact elements are designed to make electrical contact with contact elements (43) which are provided on an inner edge (42) of the cutout (41) in the base printed circuit board (11) .

13. Module printed circuit board (12a, 12b) according to Claim 12,
**characterized in that**
- the contact elements (21) of the module printed circuit board (12a, 12b) are designed in such a way that they can be connected to corresponding contact elements (43) of the base printed circuit board (11) directly by means of a solder connection.

14. Module printed circuit board (12a, 12b) according to Claim 12 or 13,
**characterized in that**
- the contact elements (21) are designed in the form of arcuate milled portions which protrude into the surface of the module printed circuit board (12a, 12b).

15. Module printed circuit board (12a, 12b) according to Claim 14,
**characterized in that**
- the contact elements (21) have a semicircular shape.

16. Module printed circuit board (12a, 12b) according to Claim 14 or 15,
**characterized in that**
- at least one contact element (61) is provided, which at least one contact element is designed to be larger than the other contact elements (21) which are arranged on the same outer edge (20) of the module printed circuit board (12a, 12b) .

17. Module printed circuit board (12a, 12b) according to one of Claims 12-16,
**characterized in that**
- the contact elements (21) of the module printed circuit board (12a, 12b) are electrically connected to conductor tracks of the module printed circuit board (12a, 12b) which are guided to the outer edges (20) of the module printed circuit board (12a, 12b).

18. Module printed circuit board (12a, 12b) according to one of Claims 9-17,
**characterized in that**
- the module printed circuit board (12a, 12b) has one or more layers, wherein the number of layers of the module printed circuit board (12a, 12b) differs from the number of layers of the base printed circuit board (11) which receives the module printed circuit board (12a, 12b), and/or **in that**
- the module printed circuit board (12a, 12b) has a surface coating or a type of equipment which is different from a surface coating or a type of equipment of the base printed circuit board (11).

19. Printed circuit board arrangement (10) comprising
- a base printed circuit board (11) for receiving electrical and/or electronic components (13a-e), wherein the base printed circuit board (11) has electrical conductor tracks, wherein at least one cutout (41) is provided in the base printed circuit board (11); and - a module printed circuit board (12a, 12b) for receiving electrical and/or electronic components (14a, 14b), wherein the module printed circuit board (12a, 12b) has electrical conductor tracks; wherein
the module printed circuit board (12a, 12b) is inserted into the cutout (41) in the base printed circuit board (11),
**characterized in that**
- the base printed circuit board (11) and the module printed circuit board (12a, 12b) are connected by a clamping connection; and
- the module printed circuit board (12a, 12b) is designed according to one of Claims 9 to 18 and/or the base printed circuit board (11) is designed according to one of Claims 1 to 8.

20. Printed circuit board arrangement (10) according to Claim 19,
**characterized in that**
- the base printed circuit board (11) and the module printed circuit board (12a, 12b) are electrically connected directly by means of a solder connection which connects their respective contact elements (21, 43).

21. Printed circuit board arrangement (10) according to Claim 20,
**characterized in that**
- the base printed circuit board (11) and the module printed circuit board (12a, 12b) are electrically connected by means of electrical or electronic components (62) which connect their respective contact elements (21, 43).

## Revendications

1. Plaquette (11) à circuit imprimé de base pour recevoir des composants (13a-e) électriques et/ou électroniques, la plaquette (11) à circuit imprimé de base ayant des pistes conductrices de l'électricité, dans laquelle il est prévu, dans la plaquette (11) à circuit imprimé de base, au moins un évidement (41) constitué pour recevoir une plaquette (12a, 12b) à circuit imprimé de module, de manière à ce que la plaquette (12a, 12b) à circuit imprimé de module insérée dans l'évidement (41) soit, avec la plaquette (11) à circuit imprimé de base, dans un plan,
dans laquelle
- l'évidement (41) de la plaquette (11) à circuit imprimé de base est conçu pour donner un assemblage par serrage avec la plaquette (12a, 12b) à circuit imprimé de module, dans laquelle, pour produire l'assemblage par serrage, l'évidement (41) de la plaquette (11) à circuit imprimé de base a, au moins sur un bord (42) intérieur, au moins un élément élastique constitué de manière à appliquer, lorsque la plaquette (12a, 12b) à circuit imprimé de module est insérée, une force de serrage sur un bord (20) extérieur correspondant de la plaquette (12a, 12b) à circuit imprimé de module,
- pour constituer le au moins un élément (22) élastique, il est prévu des fraisages (23a-c) dans au moins une partie de bord de la plaquette (11) à circuit imprimé de base et
- les fraisages (23a-c) sont de type en fente;
**caractérisée en ce que**
- deux fraisages (23a-b) s'étendent en laissant une partie (24) pleine intérieure suivant une ligne parallèle au bord (20) extérieur de la plaquette (11) à circuit imprimé de base et un autre fraisage (23c), à distance des autres fraisages (23a-b) en leur étant parallèle, s'étend dans la partie (24) pleine en laissant deux parties (25a-b) pleines de bord vers l'extérieur.

2. Plaquette (11) à circuit imprimé de base suivant la revendication 1,
**caractérisée en ce que**
- le long d'au moins un bord (42) intérieur du au moins un évidement (41) sont disposés des éléments (43) de contact, constitués pour la mise en contact électrique d'éléments (21) de contact prévus sur un bord (20) extérieur de la plaquette (12b) à circuit imprimé de module.

3. Plaquette (11) à circuit imprimé de base suivant la revendication 2,
**caractérisée en ce que**
- les éléments (43) de contact de la plaquette (11) à circuit imprimé de base sont constitués de manière à pouvoir être reliés directement, par l'intermédiaire d'une brasure, à des éléments (21) de contact correspondants de la plaquette (12b) à circuit imprimé de module.

4. Plaquette (11) à circuit imprimé de base suivant la revendication 2 ou 3,
- les éléments (43) de contact sont constitués sous la forme de fraisures arquées pénétrant dans la surface de la plaquette (11) à circuit imprimé de base.

5. Plaquette (11) à circuit imprimé de base suivant la revendication 4,
**caractérisée en ce que**
- les éléments (43) de contact ont une forme hémicirculaire.

6. Plaquette (11) à circuit imprimé de base suivant la revendication 4 ou 5,
- il est prévu au moins un élément (60) de contact, qui est plus grand que les autres éléments (43) de contact disposés sur le même bord (42) intérieur de l'évidement (41).

7. Plaquette (11) à circuit imprimé de base suivant l'une des revendications 2 à 6,
**caractérisée en ce que**
- les éléments (43) de contact sont en liaison électrique avec des pistes conductrices de la plaquette (11) à circuit imprimé de base, qui sont amenées à l'évidement (41).

8. Plaquette (11) à circuit imprimé de base suivant l'une des revendications précédentes,
**caractérisée en ce que**
- la plaquette (11) à circuit imprimé de base est une plaquette à circuit imprimé à une couche ou à plusieurs couches, le nombre des couches de la plaquette (11) à circuit imprimé de base étant différent du nombre de couches de la plaquette (12a, 12b) à circuit imprimé de module à recevoir et/ou **en ce que**
- la plaquette (11) à circuit imprimé de base a un revêtement de surface ou un type d'équipement, qui est différent d'un revêtement de surface ou d'un type d'équipement de la plaquette (12a, 12b) à circuit imprimé de module.

9. Plaquette (12a, 12b) à circuit imprimé de module pour recevoir des composants (14a, 14b) électriques et/ou électroniques, la plaquette (12a, 12b) à circuit imprimé de module ayant des pistes conductrices de l'électricité, la plaquette (12a, 12b) à circuit imprimé de module étant constituée pour être insérée dans un évidement (41) d'une plaquette (11) à circuit imprimé de base, de manière à ce que, lorsque la plaquette (12a, 12b) à circuit imprimé de module est insérée dans l'évidement (41), celle-ci soit dans un plan avec la plaquette (11) à circuit imprimé de base, dans laquelle
- la plaquette (12a, 12b) à circuit imprimé de module est conçue pour donner un assemblage par serrage dans l'évidement (41) de la plaquette (11) à circuit imprimé de base, la plaquette (12a, 12b) à circuit imprimé de module ayant, pour donner l'assemblage par serrage, au moins sur un bord (20) extérieur, au moins un élément (22) élastique constitué de manière à, lorsque la plaquette (12a, 12b) à circuit imprimé de module est insérée dans l'évidement (41) de la plaquette (11) à circuit imprimé de base, appliquer une force de serrage sur un bord (42) intérieur correspondant de l'évidement (41);
**caractérisée en ce que**
- pour constituer le au moins un élément (22) élastique, il est prévu des fraisages (23a-c) dans au moins une partie de bord de la plaquette (12a, 12b) à circuit imprimé de base et
- les fraisages (23a-c) sont de type en fente;
dans laquelle
- deux fraisages (23a-b) s'étendent en laissant une partie (24) pleine intérieure suivant une ligne parallèle au bord (20) extérieur de la plaquette (12a, 12b) à circuit imprimé de base et un autre fraisage (23c), à distance des autres fraisages (23a-b) en leur étant parallèle, s'étend dans la partie (24) pleine en laissant deux parties (25a-b) pleines de bord vers l'extérieur.

10. Plaquette (12a, 12b) à circuit imprimé de module suivant la revendication 9,
**caractérisée en ce que**
- des éléments (22) à élastique sont disposés sur deux bords extérieurs, se trouvant au dessus d'un coin, de la plaquette (12a, 12b) à circuit imprimé de module.

11. Plaquette (12a, 12b) à circuit imprimé de module suivant la revendication 9 ou 10,
**caractérisée en ce que**
- la plaquette (12a, 12b) à circuit imprimé de module a, dans la partie d'un élément (22) élastique, des moyens (27) de montage conçus pour coopérer avec un outil de montage, par lequel l'élément (22) élastique peut être mis sous précontrainte.

12. Plaquette (12a, 12b) à circuit imprimé de module suivant l'une des revendications 9 à 11,
**caractérisée en ce que**
- le long d'au moins un bord (20) extérieur de la plaquette (12a, 12b) à circuit imprimé de module, sont disposés des éléments (21) de contact constitués pour venir en contact électrique avec des éléments (43) de contact prévus sur un bord (42) intérieur de l'évidement (41) de la plaquette (11) à circuit imprimé de base.

13. Plaquette (12a, 12b) à circuit imprimé de module suivant la revendication 12,
**caractérisée en ce que**
- les éléments (21) de contact de la plaquette (12a, 12b) à circuit imprimé de module sont constitués de manière à pouvoir être reliés directement, par une brasure, à des éléments (43) de contact correspondants de la plaquette (11) à circuit imprimé de base.

14. Plaquette (12a, 12b) à circuit imprimé de module suivant la revendication 12 ou 13,
- les éléments (21) de contact sont constitués sous la forme de fraisures arquées pénétrant dans la surface de la plaquette (12a, 12b) à circuit imprimé de module.

15. Plaquette (12a, 12b) à circuit imprimé de module suivant la revendication 14,
**caractérisée en ce que**
- les éléments (21) de contact ont une forme hémicirculaire.

16. Plaquette (12a, 12b) à circuit imprimé de module suivant la revendication 14 ou 15,
- il est prévu au moins un élément (61) de contact, qui est plus grand que les autres éléments (21) de contact disposés sur le même bord (20) extérieur de la plaquette (12a, 12b) à circuit imprimé de module.

17. Plaquette (12a, 12b) à circuit imprimé de module suivant l'une des revendications 12 à 16,
**caractérisée en ce que**
- les éléments (21) de contact de la plaquette (12a, 12b) à circuit imprimé de module sont conductrices de l'électricité avec des pistes conductrices de la plaquette (12a, 12b) à circuit imprimé de module, qui sont amenées au bord (20) extérieur de la plaquette (12a, 12b) à circuit imprimé de module.

18. Plaquette (12a, 12b) à circuit imprimé de module suivant l'une des revendications 9 à 17,
**caractérisée en ce que**
- la plaquette (12a, 12b) à circuit imprimé de module a une couche ou plusieurs couches, le nombre des couches de la plaquette (12a, 12b) à circuit imprimé de module étant différent du nombre de couches de la plaquette (11) à circuit imprimé de base recevant la plaquette (12a, 12b) à circuit imprimé de module et/ou **en ce que**
- la plaquette (12a, 12b) à circuit imprimé de module a un revêtement de surface ou un type d'équipement, qui est différent d'un revêtement de surface ou d'un type d'équipement de la plaquette (11) à circuit imprimé de base.

19. Agencement (10) de plaquette à circuit imprimé, comprenant
- une plaquette (11) à circuit imprimé de base pour recevoir des composants (13a-e) électriques et/ou électroniques, la plaquette (11) à circuit imprimé de base ayant des pistes conductrices de l'électricité, au moins un évidement (41) étant prévu dans la plaquette (11) à circuit imprimé de base; et une plaquette (12a, 12b) à circuit imprimé de module pour recevoir des composants (14a, 14b) électrique et/ou électroniques, la plaquette (12a, 12b) à circuit imprimé de module ayant des pistes conductrices de l'électricité, dans lequel
la plaquette (12a, 12b) à circuit imprimé de module est insérée dans l'évidement (41) de la plaquette (11) à circuit imprimé de base,
**caractérisé en ce que**
- la plaquette (11) à circuit imprimé de base et la plaquette (12a, 12b) à circuit imprimé de module sont reliées par un assemblage par serrage et
- la plaquette (12a, 12b) à circuit imprimé de module est constituée suivant l'une des revendications 9 à 18 et/ou la plaquette (11) à circuit imprimé de base est constituée suivant l'une des revendications 1 à 8.

20. Agencement (10) de plaquette à circuit imprimé suivant la revendication 19,
**caractérisé en ce que**
- la plaquette (11) à circuit imprimé de base et la plaquette (12a, 12b) à circuit imprimé de module sont reliées électriquement directement par une brasure reliant leur élément (21, 43) de contact respectif.

21. Agencement (10) de plaquette à circuit imprimé suivant la revendication 20,
**caractérisé en ce que**
- la plaquette (11) à circuit imprimé de base et la plaquette (12a, 12b) à circuit imprimé de module sont reliées électriquement par des composants (62) électriques ou électroniques reliant leur élément (21, 43) de contact respectif.
